# EUROPEAN PATENT APPLICATION

(11) **EP 4 669 060 A1**
(43) Date of publication of application: **24.12.2025**
(21) Application number: 24909468.1
(22) Date of filing: 19.04.2024
(51) Int. Cl.: H10F 19/80, E04D 3/35, E04D 13/18

(54) **CURVED PHOTOVOLTAIC COMPONENT AND PHOTOVOLTAIC BUILDING SURFACE**

(30) Priority: 27.12.2023 CN 202323614910 U; 27.12.2023 CN 202323611571 U
(71) Applicant: Shenzhen Hello Tech Energy Co., Ltd, Shenzhen, Guangdong 518109 (CN)
(72) Inventor: TANG, Wei, Shenzhen, Guangdong 518109 (CN); SUN, Zhongwei, Shenzhen, Guangdong 518109 (CN); YU, Huajun, Shenzhen, Guangdong 518109 (CN); WANG, Zheng, Shenzhen, Guangdong 518109 (CN)
(74) Representative: Dehns Germany Partnerschaft mbB
(86) International application number: PCT/CN2024/088969
(87) International publication number: WO 2025/138500

(57) **Abstract**

Provided is a curved photovoltaic module (100). The curved photovoltaic module (100) includes a plurality of cell strings (11) including a cell (111), a crest (101), and/or a trough (103). The plurality of cell strings (11) are connected in series side by side in a tangent direction of a highest point of the crest (101). Adjacent cell strings (11) are distributed at two opposite sides of the highest point of the crest (101) and/or at two facing sides of a lowest point of the trough (103).

## Description

### CROSS-REFERENCE TO RELATED APPLICATION

This application claims priorities to and benefits of Chinese patent application Nos. 202323614910.2 and 202323611571.2, filed with China National Intellectual Property Administration on December 27, 2023, the entire contents of which are incorporated herein by reference.

### FIELD

The present disclosure relates to the field of photovoltaic technologies, and more particularly, to a curved photovoltaic module and a photovoltaic building surface.

### BACKGROUND

With the increasing popularity of building integrated photovoltaics, to better integrate with a building surface, curved photovoltaic modules that can replace traditional tiles have emerged. The curved photovoltaic modules have both aesthetic appearance and power generation functionality due to their unique shape. At present, crystalline silicon cells, which have a high photoelectric conversion efficiency, are usually used in the curved photovoltaic modules. However, due to high brittleness of the crystalline silicon cells, the cell in the curved photovoltaic module is prone to cracking when the bending curvature of the cell is too large.

### SUMMARY

Embodiments of the present disclosure provide a curved photovoltaic module and a photovoltaic building surface, which are at least configured to solve a problem that a cell in the curved photovoltaic module is prone to cracking when the bending curvature of a cell in the curved photovoltaic module is too large.

In a first aspect, the present disclosure provides a curved photovoltaic module. The curved photovoltaic module includes a cell layer including a plurality of cell strings, each of the plurality of cell strings including a plurality of cells connected in series. The curved photovoltaic module includes at least one crest and/or at least one trough. The plurality of cell strings are arranged side by side in a tangent direction of a highest point of the at least one crest. Adjacent cell strings are distributed at two opposite sides of the highest point of the at least one crest, and/or the adjacent cell strings are distributed at two facing sides of a lowest point of the at least one trough.

In a second aspect, the present disclosure provides a photovoltaic building surface. The photovoltaic building surface includes a curved photovoltaic module. The curved photovoltaic module includes a cell layer including a plurality of cell strings, each of the plurality of cell strings including a plurality of cells connected in series. The curved photovoltaic module includes at least one crest and/or at least one trough. The plurality of cell strings are arranged side by side in a tangent direction of a highest point of the at least one crest. Adjacent cell strings are distributed at two opposite sides of the highest point of the at least one crest, and/or the adjacent cell strings are distributed at two opposite sides of a lowest point of the at least one trough.

In a third aspect, the present disclosure further provides a curved photovoltaic module. The curved photovoltaic module includes a cell layer including a plurality of series groups, each of the plurality of series groups including at least one cell string, the at least one cell string including a plurality of cells connected in series. The curved photovoltaic module includes at least one crest. In a tangent direction of the highest point of the at least one crest, at least one series group is disposed at each of two opposite sides of a highest point of the at least one crest. The series groups located at the two opposite sides of the highest point of the at least one crest are connected in parallel.

In a fourth aspect, the present disclosure further provides a photovoltaic building surface. The photovoltaic building surface includes a curved photovoltaic module. The curved photovoltaic module includes a cell layer including a plurality of series groups, each of the plurality of series groups including at least one cell string, the at least one cell string including a plurality of cells connected in series. The curved photovoltaic module includes at least one crest. In a tangent direction of the highest point of the at least one crest, at least one series group is disposed at each of two opposite sides of a highest point of the at least one crest. The series groups located at the two opposite sides of the highest point of the at least one crest are connected in parallel.

In the curved photovoltaic module in the first aspect of the present disclosure and the photovoltaic building surface in the second aspect of the present disclosure, the adjacent cell strings are distributed at the two opposite sides of the highest point of the at least one crest, and/or the cell strings are distributed at the two opposite sides of the lowest point of the at least one trough, in such a manner that when the curved photovoltaic module is assembled, the bending curvature of the cell in the cell string is smaller. Therefore, the cell is less prone to cracking. In the curved photovoltaic module in the third aspect of the present disclosure and the photovoltaic building surface in the fourth aspect of the present disclosure, the series groups located at the two opposite sides of the highest point of the at least one crest are connected in parallel, in such a manner that an output current of the curved photovoltaic module is larger. When the series groups located at the two opposite sides of the highest point of the at least one crest receive different light intensities and generate different currents, the series groups that generate smaller currents may not reduce an output current of the cell layer, making the output current of the curved photovoltaic module larger.

Additional aspects and advantages of the present disclosure will be provided in part in the following description, or will become apparent in part from the following description, or can be learned from practicing of the present disclosure.

### BRIEF DESCRIPTION OF THE DRAWINGS

The above and/or additional aspects and advantages of the present disclosure will become more apparent and more understandable from the following description of embodiments taken in conjunction with the accompanying drawings.
FIG. 1 is a schematic structural view of a curved photovoltaic module according to some embodiments of the present disclosure.
FIG. 2 is a schematic structural view of a cell layer of the curved photovoltaic module in FIG. 1.
FIG. 3 is a schematic structural view of a curved photovoltaic module according to other embodiments of the present disclosure.
FIG. 4 is a schematic perspective view of a photovoltaic building surface according to some embodiments of the present disclosure.
FIG. 5 is a schematic structural view of a cell layer and a back panel according to some embodiments of the present disclosure.
FIG. 6 is a schematic structural view of a cell layer and a back panel according to some embodiments of the present disclosure.
FIG. 7 is a schematic side view of a cell string in FIG. 6 in some embodiments.
FIG. 8 is a schematic top view of a cell in the cell string in FIG. 6 in one slicing method.
FIG. 9 is a schematic top view of a cell in the cell string in FIG. 6 in another slicing method.
FIG. 10 is a schematic side view of a cell string in FIG. 6 in other embodiments.
FIG. 11 is a schematic top view of a cell in a cell string in FIG. 6.
FIG. 12 is a schematic exploded view of a curved photovoltaic module according to some embodiments of the present disclosure.
FIG. 13 is a schematic structural view of a photovoltaic building surface according to some embodiments of the present disclosure.

### DETAILED DESCRIPTION OF THE EMBODIMENTS

To make the above-mentioned objects, features, and advantages of the present disclosure more obvious and comprehensive, a detailed description of specific embodiments of the present disclosure will be given below in conjunction with the accompanying drawings. In the following description, many specific details are provided to facilitate full understanding of the present disclosure. However, the present disclosure can be implemented in many other ways than those described herein, and similar improvements can be made by those skilled in the art without contradicting the intent of the present disclosure. Therefore, the present disclosure is not limited by specific embodiments disclosed below.

In the description of the present disclosure, it should be understood that the orientation or the position indicated by terms such as "center", "longitudinal", "transverse", "length", "width", "thickness", "over", "below", "front", "rear", "left", "right", "vertical", "horizontal", "top", "bottom", "inner", "outer", "clockwise", "anti-clockwise", "axial", "radial", and "circumferential" should be construed to refer to the orientation or the position as shown in the drawings, and is only for the convenience of describing the present disclosure and simplifying the description, rather than indicating or implying that the pointed device or element must have a specific orientation, or be constructed and operated in a specific orientation, and therefore cannot be understood as a limitation of the present disclosure.

In addition, terms "first" and "second" are only used for descriptive purposes, and cannot be understood as indicating or implying relative importance or implicitly indicating the number of indicated technical features. Therefore, the features defined with "first" and "second" may explicitly or implicitly include at least one of the features. In the description of the present disclosure, "plurality" means at least two, such as two and three, unless otherwise specifically defined.

In the present disclosure, unless otherwise clearly specified and limited, terms such as "install", "connect", "connect to", "fix", and the like should be understood in a broad sense. For example, it may be a fixed connection or a detachable connection or connection as one piece; mechanical connection or electrical connection or communication; direct connection or indirect connection through an intermediate; internal communication of two components or the interaction relationship between two components, unless otherwise specifically defined. For those of ordinary skill in the art, the specific meaning of the above-mentioned terms in the present disclosure can be understood according to specific circumstances.

In the present disclosure, unless specified or limited otherwise, the first characteristic is "on" or "under" the second characteristic refers to the first characteristic and the second characteristic can be direct or via media indirect mountings, connections, and couplings. And, the first characteristic is "on", "above", "over" the second characteristic may refer to the first characteristic is right over the second characteristic or is diagonal above the second characteristic, or just refer to the horizontal height of the first characteristic is higher than the horizontal height of the second characteristic. The first characteristic is "below" or "under" the second characteristic may refer to the first characteristic is right over the second characteristic or is diagonal under the second characteristic, or just refer to the horizontal height of the first characteristic is lower than the horizontal height of the second characteristic.

It should be noted that when an element is described as being "fixed to" or "arranged on" another element, it may be directly on the other element or an intermediate element may exit. When an element is interpreted as being "connected" to another element, it may be directly connected to the other element or an intermediate element may exit simultaneously. As used herein, the terms "vertical", "horizontal", "over", "below", "left", and "right" and similar expressions are used for illustrative purposes only and are not meant to be the only means of implementation.

With the increasing popularity of building integrated photovoltaics, to better integrate with a building surface, curved photovoltaic modules that can replace traditional tiles have emerged. The curved photovoltaic modules have both aesthetic appearance and power generation functionality due to their unique shape. At present, crystalline silicon cells, which have a high photoelectric conversion efficiency, are usually used in the curved photovoltaic modules. However, due to high brittleness of the crystalline silicon cells, the cell in the curved photovoltaic module is prone to cracking when the bending curvature of the cell is too large.

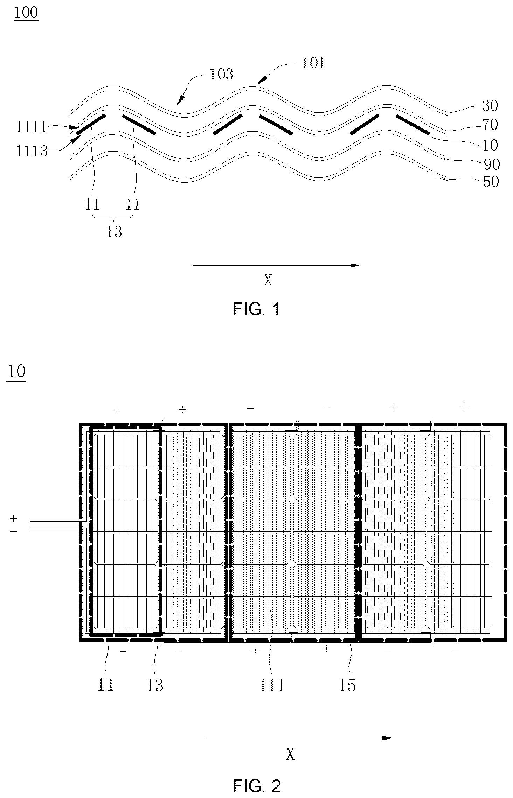

To solve this problem, as illustrated in FIG. 1 and FIG. 2, a first aspect of the present disclosure provides a curved photovoltaic module 100. The curved photovoltaic module 100 includes a cell layer 10 including a plurality of cell strings 11. Each of the plurality of cell strings 11 includes a plurality of cells 111 connected in series. The curved photovoltaic module 100 includes at least one crest 101 and/or at least one trough 103. The plurality of cell strings 11 are arranged side by side in a tangent direction X of a highest point of the crest 101. Adjacent cell strings 11 are distributed at two opposite sides of the highest point of the crest 101, and/or the adjacent cell strings 11 are distributed at two facing sides of a lowest point of the trough 103.

Specifically, the curved photovoltaic module 100 is a structure that is used to convert light energy into electrical energy to power other components and may be used as a component of a building. For example, the curved photovoltaic module 100 may power household appliances, energy storage power supplies, streetlights, or other equipment. The curved photovoltaic module 100 can generate electricity while taking into account the aesthetics of the building.

The cell layer 10 is a structure for receiving light energy and converting it into electrical energy. The number of cell strings 11 included in the cell layer 10 may be, but is not limited to, two, three, four or more. A cell string 11 may include two, three, four or more cells 111, and the plurality of cells 111 are connected in series to form a series circuit. The cell 111 is a structure for receiving light energy and converting it into electrical energy. The cell 111 includes a light receiving surface 1111 and a backlight surface 1113. A positive electrode and a negative electrode of the cell 111 may be disposed at the light receiving surface 1111 and the backlight surface 1113, respectively, or both the positive electrode and the negative electrode of the cell 111 may also be disposed at the backlight surface 1113. In an embodiment, the positive electrode and the negative electrode of the cell 111 are disposed at the light receiving surface 1111 and the backlight surface 1113, respectively. In this case, the cell 111 may be a Passivated Emitter and Rear Cell (PERC), or Tunnel Oxide Passivating Contacts (TOPCON), etc. In another embodiment, both the positive electrode and the negative electrode of the cell 111 are disposed at the backlight surface 1113. In this case, the cell 111 may be an Interdigitated Back Contact (IBC), an All Back Contact (ABC), a Hybrid Passivated Back Contact (HPBC), a Metallization Wrap-through (MWT), or a Shingled Solar Cell, etc.

In an embodiment, the adjacent cell strings 11 are distributed at the two opposite sides of the highest point of the crest 101. The cell 111 in the cell string 11 does not need to cross the crest 101, in such a manner that the deformation of the cell 111 is smaller. In a case of assembling the curved photovoltaic module 100, the deformation of the cell 111 in the cell layer 10 is smaller when the cell layer 10 is bent, in such a manner that the cell 111 is less prone to cracking. In another embodiment, the adjacent cell strings 11 are distributed at the two facing sides of the lowest point of the trough 103. The cell 111 in the cell string 11 does not need to cross the trough 103, in such a manner that the deformation of the cell 111 is smaller. In a case of assembling the curved photovoltaic module 100, the deformation of the cell 111 in the cell layer 10 is smaller when the cell layer 10 is bent, in such a manner that the cell 111 is less prone to cracking. In yet another embodiment, the adjacent cell strings 11 are distributed at the two opposite sides of the highest point of the crest 101, and the adjacent cell strings 11 are distributed at the two facing sides of the lowest point of the trough 103.

The number of crests 101 of the curved photovoltaic module 100 may be, but is not limited to, one, two, three, four or more. The number of troughs 103 of the curved photovoltaic module 100 may be, but is not limited to, one, two, three, four or more. The number of crests 101 and the number of troughs 103 may be the same or different. The deformation of the curved photovoltaic module 100 is the largest at positions near the highest point of the crest 101 and the lowest point of the trough 103. Also, since the cell 111 in the cell string 11 of the present disclosure does not need to cross the highest point of the crest 101 and the lowest point of the trough 103, the deformation of the cell 111 is smaller. In this way, the cell 111 is less prone to cracking.

In the curved photovoltaic module 100 according to the embodiments of the present disclosure, the adjacent cell strings 11 are distributed at the two opposite sides of the highest point of the crest 101, and/or the cell strings 11 are distributed at the two opposite sides of the lowest point of the trough 103, in such a manner that when the curved photovoltaic module 100 is assembled, the bending curvature of the cell 111 in the cell string 11 is smaller. Therefore, the cell 111 is less prone to cracking.

The curved photovoltaic module 100 is further described below in conjunction with FIG. 1 to FIG. 4.

As illustrated in FIG. 1 and FIG. 2, in some embodiments, the plurality of cells 111 in the cell string 11 are arranged in series in a direction perpendicular to the tangent direction of the highest point of the crest 101.

When the plurality of cells 111 in the cell string 11 are arranged in the direction perpendicular to the tangent direction of the highest point of the crest 101, in a same time period, the light intensity received by the plurality of cells 111 is substantially the same. Therefore, the current generated by each of the plurality of cells 111 is substantially the same, an output current in the cell string 11 is larger, and the output power of the curved photovoltaic module 100 is larger. In the cell string 11, it is possible to avoid a situation in which a certain cell 111 receives low light intensity, generating a current that is much smaller than the current generated by other cells 111, which lowers the output current of the cell string 11.

As illustrated in FIG. 2, in some embodiments, the cell strings 11 located at two opposite sides of a highest point of one crest 101 are connected in parallel to form a cell pack 13. A plurality of cell packs 13 are connected in series.

Since the cell pack 13 is formed by connecting the cell strings 11 at the two opposite sides of the highest point of one crest 101 in parallel, an output current of the cell pack 13 is larger. In the present disclosure, one cell pack 13 corresponds to one crest 101. When the curved photovoltaic module 100 includes a plurality of crests 101, the cell layer 10 includes the plurality of cell packs 13 connected in series, in such a manner that an output voltage of the cell layer 10 is higher, and the output power of the curved photovoltaic module 100 is larger. Each of the plurality of cell packs 13 includes the cell string 11 at the two opposite sides of the highest point of the crest 101. Therefore, the light intensity received by each of the plurality of cell packs 13 is substantially the same when an angle of the sunlight changes in different time periods. Consequently, when the plurality of cell packs 13 are connected in series, a current output by the cell layer 10 is larger.

As illustrated in FIG. 2, in some embodiments, in a direction perpendicular to the tangent direction of the highest point of the crest 101, a positive electrode and a negative electrode are led out from two opposite ends of the cell string 11, respectively. For each of the plurality of cell packs 13, the positive electrodes of the cell strings 11 are located at one end of the cell pack 13 and connected to each other to serve as a positive electrode of the cell pack 13, and the negative electrodes of the cell strings 11 are located at the other end of the cell pack 13 and connected to each other to serve as a negative electrode of the cell pack 13. Same ends of adjacent cell packs 13 have opposite polarities.

The plurality of cells 111 in the cell string 11 are connected in series through an interconnection ribbon, in such a manner that the cell string 11 leads out the positive electrode and the negative electrode at two opposite ends. Since the cell strings 11 in one cell pack 13 are connected in parallel, the positive electrodes of two cell packs 13 adjacent to one cell pack 13 are both located at the same ends, and the negative electrodes of the two cell packs 13 adjacent to the one cell pack 13 are both located at the same ends. The positive electrodes of the two cell packs 13 adjacent to the cell pack 13 are electrically connected to each other through a bus bar 15. As a result, the routing of the bus bar 15 connecting the positive electrodes of the two cell strings 11 is simpler, making the processing of the cell layer 10 more convenient. In addition, the negative electrodes of the two cell packs 13 adjacent to the cell pack 13 are electrically connected to each other through the bus bar 15. As a result, the routing of the bus bar 15 connecting the negative electrodes of the two cell strings 11 is simpler, making the processing of the cell layer 10 more convenient.

Since the adjacent cell packs 13 are connected in series, the positive electrode of one cell pack 13 and the negative electrode of an adjacent cell pack 13 are located at the same ends. Therefore, the routing of the bus bar 15 that electrically connects the positive electrode of the cell pack 13 and the negative electrode of the adjacent cell pack 13 is simpler. In addition, the negative electrode of one cell pack 13 and the positive electrode of an adjacent cell pack 13 are located at the same ends. Therefore, the routing of the bus bar 15 that electrically connects the negative electrode of the cell pack 13 and the positive electrode of the adjacent cell pack 13 is simpler, making the processing of the cell layer 10 more convenient.

As illustrated in FIG. 1 and FIG. 2, in some embodiments, the cells 111 are multi-sectioned cells 111 corresponding to a whole cell. Specifically, the cell 111 may be a 1/2 sectioned cell (the whole cell is equally cut into two cells 111), a 1/4 sectioned cell (the whole cell is equally cut into four cells 111), or a 1/6 sectioned cell (the whole cell is equally cut into six cells 111), etc. corresponding to the whole cell. An area of the 1/6 sectioned cell is smaller than that of the 1/4 sectioned cell, and an area of the 1/4 sectioned cell is smaller than that of the 1/2 sectioned cell. As an area of the cell 111 decreases, the deformation of the cell 111 becomes smaller when the curved photovoltaic module 100 is assembled, in such a manner that the cell 111 can avoid the problem of cracking during bending deformation.

As illustrated in FIG. 1 to FIG. 3, in some embodiments, a curvature radius of the curved photovoltaic module 100 is in a value range of greater than or equal to 50 mm and smaller than or equal to 150 mm.

The curvature radius of the curved photovoltaic module 100 refers to a radius of each crest 101 or a radius of each trough 103, and the radius of the crest 101 in the present disclosure is equal to that of the trough 103 in the present disclosure. After the curved photovoltaic module 100 is assembled, the curvature radius of the cell layer 10 is the same as that of the curved photovoltaic module 100. The curvature radius of the curved photovoltaic module 100 may be 50 mm, 61.3 mm, 75.4 mm, 82.4 mm, 96.7 mm, 100.7 mm, 110.1 mm, 120.5 mm, 130.4 mm, 140.8 mm, or 150 mm, etc.

Specifically, when the curvature radius of the curved photovoltaic module 100 is smaller than 50 mm, a risk of cracking of the cell 111 in the cell layer 10 easily occurs. When the curvature radius of the curved photovoltaic module 100 is greater than 200 mm, the bending curvature of the curved photovoltaic module 100 is not obvious enough and the aesthetics is not good enough. When the curvature radius of the curved photovoltaic module 100 is in a value range of greater than or equal to 25 mm and smaller than or equal to 200 mm, the bending curvature of the curved photovoltaic module 100 is more obvious and the aesthetics is better. In this case, the cell 111 in the cell layer 10 is less prone to cracking.

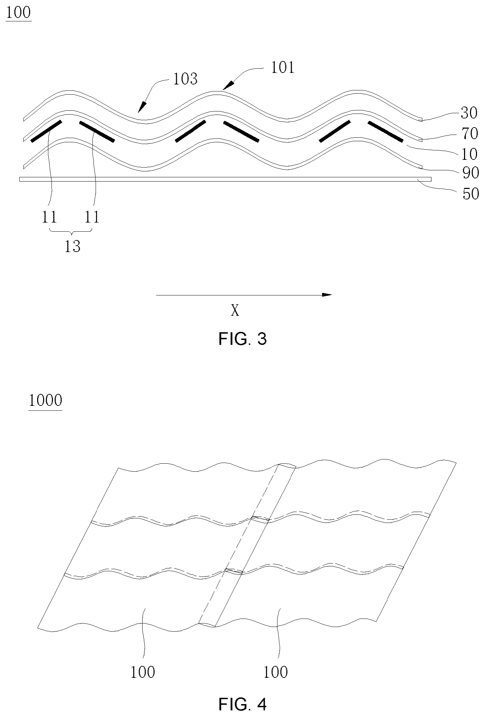

As illustrated in FIG. 1 and FIG. 3, further, in some embodiments, the curved photovoltaic module 100 further includes a front panel 30, a back panel 50, a first encapsulant film layer 70, and a second encapsulant film layer 90. The front panel 30, the first encapsulant film layer 70, the cell layer 10, the second encapsulant film layer 90, and the back panel 50 are sequentially stacked. The first encapsulant film layer 70 is configured to bond the front panel 30 and the cell layer 10, and the second encapsulant film layer 90 is configured to bond the cell layer 10 and the back panel 50.

As illustrated in FIG. 1 and FIG. 3, specifically, the front panel 30 is disposed at the light receiving surface 1111 of the cell 111 and is a structure for protecting the cell layer 10. Preferably, the light transmittance of the front panel 30 is high, for example, the light transmittance may be greater than or equal to 70%, in such a manner that most or even all of the light can pass through the front panel 30 to reach the cell layer 10. In this way, the cell layer 10 can convert received light energy into electrical energy. For example, the light transmittance of the front panel 30 may be 70%, 73.1%, 75.6%, 77%, 78.5%, 80.3%, 83%, 85.1%, 87.2%, 90.5%, 92.4%, 93.7%, 95.6%, 97.8%, or 100%, etc. The front panel 30 of the present disclosure is a light-transmitting curved front panel 30 and is made of, but is not limited to, tempered glass, semi-tempered glass, or resin material. The resin material may be polycarbonate, or polymethyl methacrylate, etc. A thickness of the front panel 30 of the present disclosure is in a range value of greater than or equal to 3 mm and smaller than or equal to 8 mm. When the thickness of the front panel 30 is smaller than 3 mm, the strength of the front panel 30 is too low, in such a manner that the front panel 30 is at risk of cracking in bad weather (such as rainstorm, snow, or hail). When the thickness of the front panel 30 is greater than 8 mm, the thickness of the front panel 30 is too thick, in such a manner that a risk of cracking the front panel 30 during bending easily occurs. Also, in this case, the weight of the front panel 30 is heavier, making the weight of the curved photovoltaic module 100 heavier, which enables the curved photovoltaic module 100 to be less likely to transport and handle. When the thickness of the front panel 30 is in the range value of greater than or equal to 3 mm and smaller than or equal to 8 mm, the strength of the front panel 30 is higher, and the front panel 30 does not have a risk of cracking in bad weather. In addition, the front panel 30 is less prone to cracking during bending, the weight of the front panel 30 is also lighter, and the curved photovoltaic module 100 is easy to transport and handle.

As illustrated in FIG. 1 and FIG. 3, the back panel 50 is disposed at the backlight surface 1113 of the cell 111 and is a structure for supporting and protecting the cell layer 10. Preferably, the back panel 50 may have predetermined waterproof performance, insulation performance, and weathering resistance performance, in such a manner that the back panel 50 can better protect the cell layer 10. In an embodiment, the back panel 50 may be a curved back panel 50 (as illustrated in FIG. 1). In this case, the back panel 50 may be made of tempered glass, or semi-tempered glass, etc. The back panel 50 has a high strength and can better support and protect the cell layer 10. In another embodiment, the back panel 50 may be a flexible back panel 50 (as illustrated in FIG. 3), and the flexible back panel 50 may bend conformably with a shape of the curved front panel 30 to form a same curved surface as the front panel 30. In this case, the back panel 50 may be made of, but is not limited to, polyethylene glycol terephthalate, copper-covered ceramic, or glass fiber composite material, etc. The back panel 50 is light in weight and has good bending performance. When the back panel 50 is the flexible back panel 50, the thickness of the back panel 50 is in a value range of greater than or equal to 0.3 mm and smaller than or equal to 0.7 mm. When the thickness of the back panel 50 is smaller than 0.3 mm, the weathering resistance performance of the back panel 50 is poor, which shortens the service life of the back panel 50. In this case, the water blocking function of the back panel 50 is poor. Therefore, in a high humidity environment, there is a risk that water vapor in the air enters the curved photovoltaic module 100 from the back panel 50. When the thickness of the back panel 50 is greater than 0.7 mm, the thickness of the back panel 50 is too thick and is difficult to bend conformably with the shape of the front panel 30. When the thickness of the back panel 50 is in the range value of greater than or equal to 0.3 mm and smaller than or equal to 0.7 mm, the back panel 50 has better weathering resistance performance and water blocking performance and can bend conformably with the shape of the front panel 30 well.

As illustrated in FIG. 1 and FIG. 3, the first encapsulant film layer 70 is a high cut-off encapsulant film. The first encapsulant film layer 70 can prevent ultraviolet rays from entering the cell layer 10 and the back panel 50 while transmitting light. The ultraviolet rays entering the cell layer 10 and the back panel 50 can accelerate the aging of the cell 111 and the back panel 50, shortening the service life of the cell 111 and the back panel 50. The first encapsulant film layer 70 of the present disclosure may block the ultraviolet rays, which can protect the cell layer 10 and the back panel 50 well. Preferably, the light transmittance of the first encapsulant film layer 70 may be greater than or equal to 70%. In a process that light passes through the first encapsulant film layer 70 to reach the cell layer 10, the light loss through the first encapsulant film layer 70 is small, making a utilization rate of light by the cell 111 high. The first encapsulant film layer 70 may be made of, but is not limited to, ethylene-vinyl acetate copolymer, polyolefin elastomer, polyvinyl butyral, or thermoplastic elastomer, etc. The thickness of the first encapsulant film layer 70 of the present disclosure is in a value range of greater than or equal to 0.3 mm and smaller than or equal to 0.8 mm. When the thickness of the first encapsulant film layer 70 is smaller than 0.3 mm, the bonding strength of the first encapsulant film layer 70 is poor. Also, when the front panel 30 is pressed against the cell layer 10 through the first encapsulant film layer 70, bubbles are likely to appear between the front panel 30 and the cell layer 10. When the thickness of the first encapsulant film layer 70 is greater than 0.8 mm, a time period required for the front panel 30 to be pressed against the cell layer 10 through the first encapsulant film layer 70 is longer, in such a manner that a processing efficiency of the curved photovoltaic module 100 is lower. In this case, the material used for the first encapsulant film layer 70 is more, making costs of the first encapsulant film layer 70 higher. When the thickness of the first encapsulant film layer 70 is in the value range of greater than or equal to 0.3 mm and smaller than or equal to 0.8 mm, the bonding strength of the first encapsulant film layer 70 is higher, the bonding between the front panel 30 and the cell layer 10 is stronger. In addition, the time period required for the front panel 30 to be pressed against the cell layer 10 through the first encapsulant film layer 70 is shorter, making the processing efficiency of the curved photovoltaic module 100 higher.

As illustrated in FIG. 1 and FIG. 3, the second encapsulant film layer 90 is a high light-transmitting encapsulant film, for example, the light transmittance of the second encapsulant film layer 90 may be greater than or equal to 70%. When the second encapsulant film layer 90 is the light-transmitting encapsulant film, the cell 111 may be a generation cell 111 capable of generating power on both sides. In this case, the two opposite sides of the cell 111 can absorb the light and convert light energy into electrical energy. The second encapsulant film layer 90 may be made of, but is not limited to, ethylene-vinyl acetate copolymer, polyolefin elastomer, or polyvinyl butyral, etc. The thickness of the second encapsulant film layer 90 of the present disclosure is in a value range of greater than or equal to 0.3 mm and smaller than or equal to 0.8 mm. When the thickness of the second encapsulant film layer 90 is smaller than 0.3 mm, the bonding strength of the second encapsulant film layer 90 is poorer. Also, when the back panel 50 is pressed against the cell layer 10 through the second encapsulant film layer 90, bubbles are likely to appear between the back panel 50 and the cell layer 10. When the thickness of the second encapsulant film layer 90 is greater than 0.8 mm, the time period required for the back panel 50 to be pressed against the cell layer 10 through the second encapsulant film layer 90 is longer, in such a manner that the processing efficiency of the curved photovoltaic module 100 is lower. In this case, the material used for the second encapsulant film layer 90 is more, making costs of the second encapsulant film layer 90 higher. When the thickness of the second encapsulant film layer 90 is in the value range of greater than or equal to 0.3 mm and smaller than or equal to 0.8 mm, the bonding strength of the second encapsulant film layer 90 is higher, making the bonding between the back panel 50 and the cell layer 10 stronger. In addition, the time period required for the back panel 50 to be pressed against the cell layer 10 through the second encapsulant film layer 90 is shorter, making the processing efficiency of the curved photovoltaic module 100 higher.

As illustrated in FIG. 1, in an embodiment, the front panel 30 is a curved front panel 30, and the cell layer 10 bends conformably with the shape of the front panel 30. When the curved photovoltaic module 100 is assembled, the cell layer 10 may bend conformably with the shape of the front panel 30 to form a same curved surface as the front panel 30. As illustrated in FIG. 3, in another embodiment, the front panel 30 is a curved front panel 30, the back panel 50 is also a curved back panel 50, and the cell layer 10 bends conformably with shapes of both the front panel 30 and the back panel 50. When the curved photovoltaic module 100 is assembled, the cell layer 10 may bend conformably with the shapes of both the front panel 30 and the back panel 50 to form the same curved surface as the front panel 30.

As illustrated in FIG. 4, a second aspect of the present disclosure provides a photovoltaic building surface 1000. The photovoltaic building surface 1000 includes a plurality of curved photovoltaic modules 100 according to any one of the above embodiments (including but not limited to those illustrated in FIG. 1 to FIG. 3), and the plurality of curved photovoltaic modules 100 are interconnected.

In the photovoltaic building surface 1000 according to embodiments of the present disclosure, the adjacent cell strings 11 are distributed at the two opposite sides of the highest point of the crest 101, and/or the adjacent cell strings 11 are distributed at the two facing sides of the lowest point of the trough 103, in such a manner that when the curved photovoltaic module 100 is assembled, the bending curvature of the cell 111 in the cell string 11 is smaller. Therefore, the cell 111 is less prone to cracking.

In addition, with the increasing popularity of building integrated photovoltaics, to better integrate with a building surface, photovoltaic modules that can replace traditional tiles have emerged. The photovoltaic modules may be flat photovoltaic modules or curved photovoltaic modules. Compared with the flat photovoltaic modules, the curved photovoltaic modules have both aesthetic appearance and power generation functionality due to their unique shape. However, since the plurality of cell strings in the cell layer are distributed at different positions of the curved photovoltaic module, the light intensity received by the plurality of cell strings in a same time period is different, in such a manner that currents generated in the plurality of cell strings are different. The cell strings that receive low light intensity generate small currents, which can reduce an output current of the curved photovoltaic module.

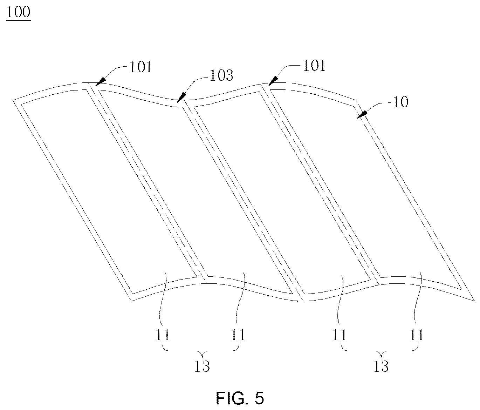

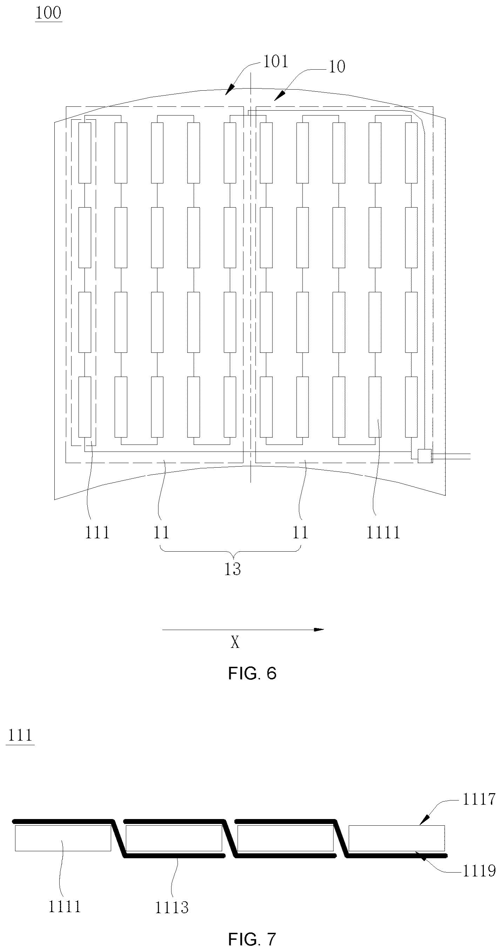

To solve this problem, as illustrated in FIG. 5 and FIG. 6, a third aspect of the present disclosure also provides a curved photovoltaic module 100. The curved photovoltaic module 100 includes a cell layer 10. The cell layer 10 includes a plurality of series groups 11. Each of the plurality of series groups 11 includes at least one cell string 111. The cell string 111 includes a plurality of cells 1111 connected in series. The curved photovoltaic module 100 includes at least one crest 101. In a tangent direction X of a highest point of the crest 101, at least one series group 11 is disposed at each of two opposite sides of the highest point of the crest 101, and the series groups 11 located at the two opposite sides of the highest point of the crest 101 are connected in parallel.

Specifically, the curved photovoltaic module 100 is a structure that is used to convert light energy into electrical energy to power other components and may be used as a component of a building. For example, the curved photovoltaic module 100 may power household appliances, energy storage power supplies, streetlights, and other equipment. The curved photovoltaic module 100 can generate electricity while taking into account the aesthetics of the building.

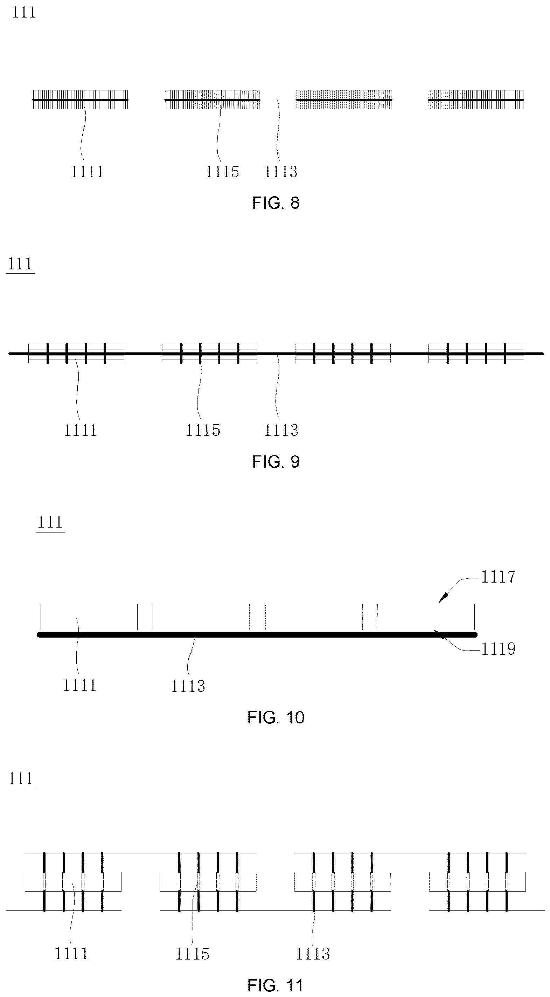

The cell layer 10 is a structure for receiving light energy and converting it into electrical energy. Each of the plurality of series groups 11 includes one or more cell strings 111. The cell string 111 includes one or more cells 1111. One cell string 111 may include two, three, four or more cells 1111, and the plurality of cells 1111 are connected in series to form a series circuit. The cell 1111 is a structure for receiving light energy and converting it into electrical energy. In conjunction with FIG. 7 and FIG. 10, the cell 1111 includes a light receiving surface 1117 and a backlight surface 1119. A positive electrode and a negative electrode of the cell 1111 may be disposed at the light receiving surface 1117 and the backlight surface 1119, respectively, or both the positive electrode and the negative electrode of the cell 1111 may be disposed at the backlight surface 1119. In an embodiment, the positive electrode and the negative electrode of the cell 1111 are disposed at the light receiving surface 1117 and the backlight surface 1119, respectively. In this case, the cell 1111 may be a Passivated Emitter and Rear Cell (PERC), or Tunnel Oxide Passivating Contacts (TOPCON), etc. In another embodiment, both the positive electrode and the negative electrode of the cell 1111 are disposed at the backlight surface 1119. In this case, the cell 1111 may be an Interdigitated Back Contact (IBC), an All Back Contact (ABC), a Hybrid Passivated Back Contact (HPBC), or a Metallization Wrap-through (MWT), etc.

The number of crests 101 of the curved photovoltaic module 100 may be, but is not limited to, one, two, three, four, or more. When a plurality of crests 101 are provided, a trough 103 are connected between the crests 101. Since there is a predetermined undulation height between the crest 101 and the trough 103, when the sunlight irradiates the curved photovoltaic module 100, the light intensity received by the plurality of series groups 11 is different. Generally, in a same time period, the light intensity received at the two opposite sides of the highest point of the crest 101 is different, in such a manner that currents generated in the series groups 11 at the two opposite sides of the highest point of the crest 101 are different. The series group 11 that receives high light intensity generates a large current, while the series group 11 that receives low light intensity generates a small current. If the series groups 11 at the two opposite sides of the highest point of the crest 101 are connected in series, currents at all points in a series circuit are equal. Therefore, a series group 11 that generates a smaller current may reduce an output current of the cell layer 10, making an output current of the curved photovoltaic module 100 smaller. The series groups 11 at the two opposite sides of the highest point of the crest 101 of the present disclosure are connected in parallel, and a current of a parallel circuit is a sum of currents generated by the series groups 11 at the two opposite sides of the highest point of the crest 101. Therefore, the output current of the cell layer 10 is larger, making the output current of the curved photovoltaic module 100 larger.

In the curved photovoltaic module 100 according to the embodiments of the present disclosure, the series groups 11 located at the two opposite sides of the highest point of the crest 101 are connected in parallel, in such a manner that the output current of the curved photovoltaic module 100 is larger. When the series groups 11 located at the two opposite sides of the highest point of the crest 101 receive different light intensity and generate different currents, the series group 11 that generates a smaller current may not lower the output current of the cell layer 10. In this way, the output current of the curved photovoltaic module 100 is larger.

The curved photovoltaic module 100 is further described below in conjunction with FIG. 6 to FIG. 13.

As illustrated in FIG. 6, in some embodiments, each of the plurality of series groups 11 includes a cell string 111. In this case, a structure of the series group 11 is simpler, making the processing more convenient. Each of the plurality of cells 1111 in the cell string 111 has a larger area, and thus an area of each of the plurality of cells 1111 that can receive light is larger. Since one series group 11 is disposed at either side of the two opposite sides of the highest point of the crest 101, when the one series group 11 includes a cell string 111, the light intensity received by the plurality of cells 1111 in the one cell string 111 is substantially the same, in such a manner that the output current of the one cell string 111 is also larger (a problem of reducing the output current of the cell string 111 due to lower light intensity received by a predetermined cell 1111 can be avoided).

As illustrated in FIG. 6, in other embodiments, each of the plurality of series groups 11 includes a plurality of cell strings 111 connected in series and/or in parallel. In this case, an area of the cell 1111 in each of the plurality of cell strings 111 is smaller. When the curved photovoltaic module 100 is assembled, the cell layer 10 needs to be bent and deformed. When the area of the cell 1111 is smaller, an area covered by the cell 1111 on the curved photovoltaic module 100 is smaller. Therefore, the deformation of the cell 1111 during bending deformation is smaller, making the cell 1111 less prone to cracking.

Each of the plurality of series groups 11 may include two, three, four or more cell strings 111. In an example, the plurality of cell strings 111 are connected in series, and in this case, an output voltage of each of the plurality of series groups 11 is higher. In another example, the plurality of cell strings 111 are connected in parallel, in such a manner that an output current of each of the plurality of series groups 11 is larger. In the present disclosure, the plurality of cell strings 111 in each of the plurality of series groups 11 are connected in series. Therefore, the output voltage of the series group 11 is higher, leading to a higher output voltage of the cell layer 10. Also, since the one series group 11 is disposed at the either side of the two opposite sides of the highest point of the crest 101, when the one series group 11 includes the plurality of cell strings 111 connected in series, the light intensity received by the plurality of cell strings 111 is substantially the same, in such a manner that the output current of the one series group 11 is also larger (a problem of reducing the output current of the series group 11 due to lower light intensity received by a predetermined cell string 111 can be avoided).

As illustrated in FIG. 5, in some embodiments, one series group 11 is provided at either side of the two opposite sides of the highest point of the crest 101. In this case, in the tangent direction X of the highest point of the crest 101, a series group 11 almost covers an entire side of the crest 101, in such a manner that the cell layer 10 can cover the curved photovoltaic module 100 as much as possible. In this way, a power generation efficiency per unit area on the curved photovoltaic module 100 is higher.

In other embodiments, multiple series groups 11 connected in series and/or in parallel are provided at the either side of the two opposite sides of the highest point of the crest 101. In this case, the number of series groups 11 located at one side of the crest 101 may be, but is not limited to, two, three, four or more. The number of series groups 11 located at both sides of the crest 101 may be the same or different. In an example, multiple series groups 11 located at one side of the crest 101 are connected in series, in such a manner that the output voltage of the cell layer 10 is higher. In another example, multiple series groups 11 located at one side of the crest 101 are connected in parallel, in such a manner that the output current of cell layer 10 is higher. When multiple series groups 11 are provided at one side of the crest 101, in the tangent direction X of the highest point of the crest 101, multiple series groups 11 almost cover the entire side of the crest 101, in such a manner that the cell layer 10 can cover the curved photovoltaic module 100 as much as possible. In this way, the power generation efficiency per unit area on the curved photovoltaic module 100 is higher.

As illustrated in FIG. 5 and FIG. 6, in some embodiments, the series group 11 includes a cell string 111, and one series group 11 is provided at the either side of the two opposite sides of the highest point of the crest 101. In other embodiments, the series group 11 includes a cell string 111, multiple series groups 11 are provided at the either side of the two opposite sides of the highest point of the crest 101, and the multiple series groups 11 are connected in series and/or in parallel. In still other embodiments, the series group 11 includes the plurality of cell strings 111 connected in series and/or in parallel, and one series group 11 is provided at the either side of the two opposite sides of the highest point of the crest 101. In yet other embodiments, the series group 11 includes the plurality of cell strings 111 connected in series and/or in parallel, the multiple series groups 11 are provided at the either side of the two opposite sides of the highest point of the crest 101, and the multiple series groups 11 are connected in series and/or in parallel.

As illustrated in FIG. 5 and FIG. 6. In some embodiments, the series groups 11 located at the two opposite sides of the highest point of one crest 101 are connected in parallel to form a cell pack 13, and a plurality of cell packs 13 are connected in series.

Since the cell pack 13 is formed by connecting the series groups 11 at the two opposite sides of the highest point of the one crest 101 in parallel, an output current of the cell pack 13 is larger. One cell pack 13 corresponds to one crest 101. When the curved photovoltaic module 100 includes the plurality of crests 101, the cell layer 10 includes the plurality of cell packs 13 connected in series. In this way, the output voltage of the cell layer 10 is higher, and thus the output power of the curved photovoltaic module 100 is larger. Each of the plurality of cell packs 13 includes the series group 11 at the two opposite sides of the highest point of the crest 101. Therefore, the light intensity received by each of the plurality of cell packs 13 is substantially the same when an angle of the sunlight changes in different time periods. Consequently, when the plurality of cell packs 13 are connected in series, a current output by the cell layer 10 is larger.

As illustrated in FIG. 6 to FIG. 11, in some embodiments, the cells 1111 are multi-sectioned cells 111 corresponding to a whole cell. For example, the cell 1111 may be a 1/2 sectioned cell (the whole cell is equally cut into two cells 1111), a 1/4 sectioned cell (the whole cell is equally cut into four cells 1111), or a 1/6 sectioned cell (the whole cell is equally cut into six cells 1111), etc. corresponding to the whole cell. An area of the 1/6 sectioned cell is smaller than that of the 1/4 sectioned cell, and an area of the 1/4 sectioned cell is smaller than that of the 1/2 sectioned cell. As an area of the cell 1111 decreases, the deformation of the cell 1111 becomes smaller when the curved photovoltaic module 100 is assembled, in such a manner that the cell 1111 can avoid the problem of cracking during bending deformation.

As illustrated in FIG. 7 and FIG. 8, in some embodiments, when the positive electrode and the negative electrode of the cell 1111 are disposed at the light receiving surface 1117 and the backlight surface 1119, respectively, the cell 1111 may be formed by cutting the whole cell in a direction parallel to a main grid line 1115. Each of the light receiving surface 1117 and the backlight surface 1119 at least includes a main grid line 1115. The plurality of cells 1111 in the cell string 111 are arranged in an extension direction of the main grid line 1115. The main grid line 1115 of the light receiving surface 1117 of the cell 1111 is electrically connected to the main grid line 1115 of the backlight surface 1119 of an adjacent cell 1111. A polarity led out from the main grid line 1115 of the light receiving surface 1117 of the cell 1111 is opposite to a polarity led out from the main grid line 1115 of the backlight surface 1119 of the adjacent cell 1111.

Specifically, the main grid line 1115 is a metal wire disposed at a surface of the cell 1111. Preferably, a plurality of main grid lines 1115 are provided at the cell 1111. When the positive electrode and the negative electrode of the cell 1111 are disposed at the light receiving surface 1117 and the backlight surface 1119, respectively, the plurality of main grid lines 1115 are also disposed at the light receiving surface 1117 and the backlight surface 1119, respectively. The main grid line 1115 is configured to lead out the positive electrode and the negative electrode of the cell 1111. The main grid line 1115 is welded to a welding strip 1113, in such a manner that two adjacent cells 1111 are connected in series. In addition, the main grid line 1115 may also collect and transmit currents generated by the cell 1111, cooperate with the welding strip 1113, and output the currents generated at the cell string 111 to other circuits.

The main grid line 1115 of the light receiving surface 1117 of one cell 1111 is connected to the main grid line 1115 of the backlight surface 1119 of an adjacent cell 1111 through the welding strip 1113, enabling a series connection among the plurality of cells 1111 to form the cell string 111. For example, the main grid line 1115 of the light receiving surface 1117 leads out the negative electrode of the cell 1111, the main grid line 1115 of the backlight surface 1119 leads out the positive electrode of the cell 1111, and the welding strip 1113 is electrically connected to the positive electrode and the negative electrode of adjacent cells 1111, to allow a series connection between two cells 1111.

As illustrated in FIG. 7 and FIG. 9, in other embodiments, when the positive electrode and the negative electrode of the cell 1111 are disposed at the light receiving surface 1117 and the backlight surface 1119, respectively, the cell 1111 may be formed by cutting the whole cell in a direction perpendicular to the main grid line 1115. In this case, the number of main grid lines 1115 of the light receiving surface 1117 of the cell 1111 is the same as the number of main grid lines 1115 of the light receiving surface 1117 of the whole cell, and the number of main grid lines 1115 of the backlight surface 1119 of the cell 1111 is also the same as the number of main grid lines 1115 of the backlight surface 1119 of the whole cell. The number of main grid lines 1115 of the light receiving surface 1117 of the cell 1111 may be, but is not limited to, one, two, three, four or more. The number of main grid lines 1115 of the backlight surface 1119 of the cell 1111 may be, but is not limited to, one, two, three, four or more. When the plurality of main grid lines 1115 are provided, the main grid line 1115 has a better effect of collecting the currents of the cell 1111.

In this case, the plurality of cells 1111 in the cell string 111 are arranged in the extension direction perpendicular to the main grid line 1115, and the main grid line 1115 of the light receiving surface 1117 of the cell 1111 is electrically connected to the main grid line 1115 of the backlight surface 1119 of the adjacent cell 1111. The polarity led out from the main grid line 1115 of the light receiving surface 1117 of the cell 1111 is opposite to the polarity led out from the main grid line 1115 of the backlight surface 1119 of the adjacent cell 1111.

After a first welding strip 1113 is welded to each main grid line 1115 in the extension direction of the main grid line 1115, a second welding strip 1113 is connected to the first welding strip 1113 in the extension direction perpendicular to the main grid line 1115, to enable a series connection between two adjacent cells 1111. The first welding strip 1113 of the light receiving surface 1117 of one cell 1111 is connected to the first welding strip 1113 of the backlight surface 1119 of another adjacent cell 1111 through the second welding strip 1113, enabling a series connection among the plurality of cells 1111 to form the cell string 111. For example, the main grid line 1115 of the light receiving surface 1117 leads out the negative electrode of the cell 1111, and the main grid line 1115 of the backlight surface 1119 leads out the positive electrode of the cell 1111. The first welding strip 1113 is electrically connected to the main grid line 1115, and the second welding strip 1113 is electrically connected to the first welding strip 1113, in such a manner that the second welding strip 1113 may be electrically connected to the positive electrode and the negative electrode of the adjacent cells 1111, enabling the series connection between the two cells 1111.

As illustrated in FIG. 10 and FIG. 11, in yet other embodiments, when both the positive electrode and the negative electrode of the cell 1111 are disposed at the backlight surface 1119, the cell 1111 may be formed by cutting the whole cell in the direction perpendicular to the main grid line 1115. In this case, the number of main grid lines 1115 of the backlight surface 1119 of the cell 1111 is the same as the number of main grid lines 1115 of the backlight surface 1119 of the whole cell. The number of main grid lines 1115 of the backlight surface 1119 of the cell 1111 may be, but is not limited to, two, three, four or more. When the plurality of main grid lines 1115 are provided, the main grid lines 1115 have the better effect of collecting the currents of the cell 1111.

In this case, the plurality of cells 1111 in the cell string 111 are arranged in the extension direction perpendicular to the main grid line 1115, and the main grid line 1115 of the backlight surface 1119 of the cell 1111 is electrically connected to the main grid line 1115 of the backlight surface 1119 of the adjacent cell 1111. The polarity led out from the main grid line 1115 on one side of the backlight surface 1119 of the cell 1111 is opposite to the polarity led out from the main grid line 1115 on a same side of the backlight surface 1119 of the adjacent cell 1111.

After the first welding strip 1113 is welded to each main grid line 1115 in the extension direction of the main grid line 1115, the second welding strip 1113 is connected to the first welding strip 1113 in the extension direction perpendicular to the main grid line 1115, to enable the series connection among the two adjacent cells 1111. A portion of the main grid line 1115 at the backlight surface 1119 is used to lead out the positive electrode of the cell 1111, and lead out the positive electrode of the cell 1111 from one side of the cell 1111. Another portion of the main grid line 1115 at the backlight surface 1119 is used to lead out the negative electrode of the cell 1111, and lead out the negative electrode of the cell 1111 from another side of the cell 1111. For example, as illustrated in FIG. 11, in a width direction of the cell 1111, the main grid line 1115 of one cell 1111 leads out the positive electrode from one side of the cell 1111, and the main grid line 1115 of the other adjacent cell 1111 leads out the negative electrode from a same side of the cell 1111. After the first welding strip 1113 is electrically connected to the main grid line 1115, the second welding strip 1113 is electrically connected to the first welding strip 1113, in such a manner that the second welding strip 1113 may be electrically connected to the positive electrode and the negative electrode of the adjacent cell 1111 from the side of the cell 1111, enabling the series connection between the two cells 1111.

As illustrated in FIG. 6, in some embodiments, an extension direction of the cell string 111 is perpendicular to the tangent direction X of the highest point of the crest 101. When the series group 11 includes a plurality of cell strings 111, the plurality of cell strings 111 are arranged in the tangent direction X of the highest point of the crest 101.

Specifically, when the extension direction of the cell string 111 is perpendicular to the tangent direction X of the highest point of the crest 101, the plurality of cells 1111 in the cell string 111 are arranged in a direction perpendicular to the tangent direction X of the highest point of the crest 101. In different time periods, when an irradiation angle of the sunlight changes, the light intensity received by the plurality of cells 1111 in the cell string 111 is substantially the same, in such a manner that the output current of the cell string 111 is larger. When the plurality of cell strings 111 in the series group 11 are arranged in the tangent direction X of the highest point of the crest 101, in a case of assembling the curved photovoltaic module 100, when the cell layer 10 is bent and deformed, the deformation of the cell 1111 in each of the plurality of cell strings 111 is smaller. In this way, the cell 1111 is less prone to cracking during bending.

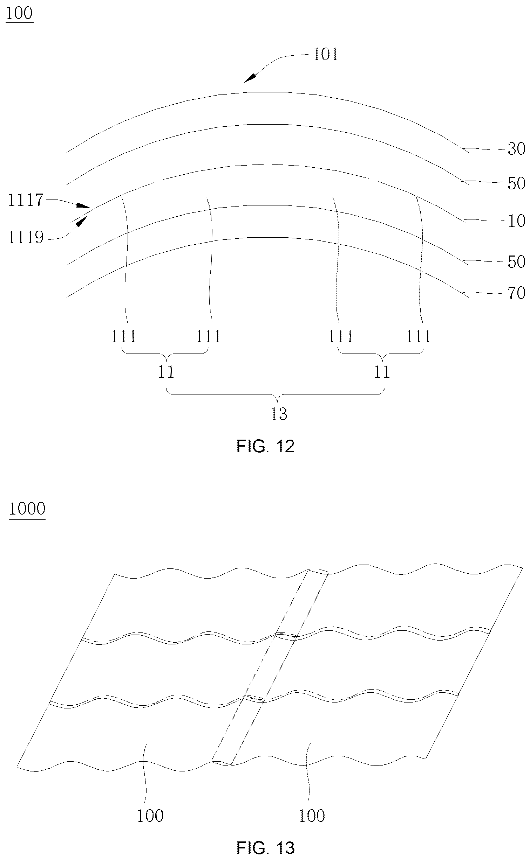

As illustrated in FIG. 12, in some embodiments, the curved photovoltaic module 100 further includes a front panel 30, encapsulant film layers 50, and a back panel 70. The front panel 30, the encapsulant film layer 50, the cell layer 10, the encapsulant film layer 50, and the back panel 70 are sequentially stacked. The encapsulant film layer 50 is configured to bond the front panel 30 and the cell layer 10, and the encapsulant film layer 50 is configured to bond the cell layer 10 and the back panel 70.

Specifically, the front panel 30 is disposed at the light receiving surface 1117 of the cell 1111 and is a structure for protecting the cell layer 10. Preferably, the light transmittance of the front panel 30 is higher, for example, the light transmittance may be greater than or equal to 70%, in such a manner that most or even all of the light can pass through the front panel 30 to reach the cell layer 10. In this way, the cell layer 10 can convert received light energy into electrical energy. For example, the light transmittance of the front panel 30 may be 70%, 73.1%, 75.6%, 77%, 78.5%, 80.3%, 83%, 85.1%, 87.2%, 90.5%, 92.4%, 93.7%, 95.6%, 97.8%, or 100%, etc. The front panel 30 may be a hard front panel 30 or a flexible front panel 30 with a curved surface, and may be made of, but is not limited to, transparent glass and polycarbonate plastic.

The back panel 70 is disposed at the backlight surface 1119 of the cell 1111 and is a structure for supporting and protecting the cell layer 10. Preferably, the back panel 70 may have predetermined waterproof performance, insulation performance, and weathering resistance performance, in such a manner that the back panel 70 can better protect the cell layer 10. In an embodiment, the back panel 70 may be a hard back panel 70 with a curved surface. In this case, the back panel 70 may be tempered glass or semi-tempered glass. The back panel 70 has a high strength and can better support and protect the cell layer 10. In another embodiment, the back panel 70 may be a flexible back panel 70, and the flexible back panel 70 may bend conformably with a shape of the curved front panel 30 to form a same curved surface as the front panel 30. In this case, the back panel 70 may be made of, but is not limited to, polyethylene glycol terephthalate (PET) or a composite material of PET. The back panel 70 is light in weight and has good bending performance.

The encapsulant film layer 50 and the encapsulant film layer 50 are structures for bonding two other elements to allow a tight connection between the two elements. For example, the encapsulant film layer 50 may be used to bond the front panel 30 and the cell layer 10, and the encapsulant film layer 50 may be used to bond the cell layer 10 and the back panel 70. The encapsulant film layer 50 and the encapsulant film layer 50 may be made of ethylene vinyl acetate (EVA), poly olefin elastomer (POE), polyvinyl butyral (PVB), or thermoplastic elastomer (TPO), etc. In this case, the light transmittance of the encapsulant film layer 50 and the encapsulant film layer 50 is higher, and the light loss through the encapsulant film layer 50 and the encapsulant film layer 50 is smaller during a process of light passing through the encapsulant film layer 50 and the encapsulant film layer 50 to reach the cell layer 10. Therefore, the cell has a higher utilization rate of the light. For example, the light transmittance of the encapsulant film layer 50 and the encapsulant film layer 50 may be greater than or equal to 70%, such as 70%, 75.2%, 79.5%, 82.1%, 86.3%, 88.2%, 93.1%, 94.2%, 98.5%, or 100%.

As illustrated in FIG. 12, in some embodiments, the front panel 30 is a curved front panel 30, and the cell layer 10 bends conformably with a shape of the front panel 30. When the curved photovoltaic module 100 is assembled, the cell layer 10 may bend conformably with the shape of the front panel 30 to form the same curved surface as the front panel 30. Since the extension direction of the cell string 111 in the cell layer 10 is perpendicular to the tangent direction X of the highest point of the crest 101, and the plurality of cell strings 111 are arranged in the tangent direction X of the highest point of the crest 101, the cell layer 10 is less prone to cracking during bending. In this case, the bending curvature of the front panel 30 may be larger, allowing the cell layer 10 to bend conformably with the shape of the front panel 30 and to be less prone to cracking. Consequently, the curved photovoltaic module 100 has better aesthetics.

As illustrated in FIG. 12, in other embodiments, the back panel 70 is a curved back panel 70, and the cell layer 10 bends conformably with a shape of the back panel 70. When the curved photovoltaic module 100 is assembled, the cell layer 10 may bend conformably with the shape of the back panel 70 to form a same curved surface as the back panel 70. Since the extension direction of the cell string 111 in the cell layer 10 is perpendicular to the tangent direction X of the highest point of the crest 101, and the plurality of cell strings 111 are arranged in the tangent direction X of the highest point of the crest 101, the cell layer 10 is less prone to cracking during bending. In this case, the bending curvature of the back panel 70 may be larger, allowing the cell layer 10 to bend conformably with the shape of the back panel 70 and to be less prone to cracking. Consequently, the curved photovoltaic module 100 has the better aesthetics.

As illustrated in FIG. 12, in yet other embodiments, the front panel 30 is the curved front panel 30, and the cell layer 10 bends conformably with the shape of the front panel 30. Also, the back panel 70 is the curved back panel 70, and the cell layer 10 bends conformably with the shape of the back panel 70. In this case, the front panel 30 and the back panel 70 are the same curved surfaces, and the cell layer 10 may bend conformably with the shapes of the front panel 30 and the back panel 70 to form the same curved surface as the front panel 30 and the back panel 70. Since the extension direction of the cell string 111 in the cell layer 10 is perpendicular to the tangent direction X of the highest point of the crest 101, and the plurality of cell strings 111 are arranged in the tangent direction X of the highest point of the crest 101, the cell layer 10 is less prone to cracking during bending. In this case, the bending curvature of the front panel 30 and the back panel 70 may be larger, allowing the cell layer 10 to bend conformably with the shapes of the front panel 30 and the back panel 70 and to be less prone to cracking. Consequently, the curved photovoltaic module 100 has the better aesthetics.

As illustrated in FIG. 13, a fourth aspect of the present disclosure also provides another photovoltaic building surface 1000. The photovoltaic building surface 1000 includes the plurality of curved photovoltaic modules 100 according to any of the above embodiments (including but not limited to those shown in FIG. 5 to FIG. 12), and the plurality of curved photovoltaic modules 100 are interconnected.

In the photovoltaic building surface 1000 according to embodiments of the present disclosure, the series groups 11 located at the two opposite sides of the highest point of the crest 101 are connected in parallel, in such a manner that an output current of the curved photovoltaic module 100 is larger. When the series groups 11 located at the two opposite sides of the highest point of the crest 101 receive different light intensity and generate different currents, the series group 11 that generate a smaller current may not lower an output current of the cell layer 10. In this way, the output current of the curved photovoltaic module 100 is larger.

Any combination of technical features in the above-described embodiments may be adopted. To make the description simple, all possible combinations of the technical features in the above-described embodiments are not described. However, as long as there is no conflict between the technical features in the embodiments, which should be considered in the scope of this specification. In addition, other implementations may be derived from the above-described embodiments, such that structural and logical substitutions and changes may be made without departing from the scope of the present disclosure.

The above embodiments illustrate merely some implementations of the present disclosure, which are described in details but are not construed to limit the scope of the present disclosure. It should be pointed that, for those skilled in the art, without departing from the principle of the present disclosure, various changes and improvements may be made, which are covered by the protection scope of the present disclosure. Therefore, the protection scope of the present disclosure is according to the appended claims.

## Claims

1. A curved photovoltaic module, comprising:
a cell layer comprising a plurality of cell strings, each of the plurality of cell strings comprising a plurality of cells connected in series;
wherein the curved photovoltaic module comprises at least one crest and/or at least one trough, the plurality of cell strings being arranged side by side in a tangent direction of a highest point of the at least one crest, wherein:
adjacent cell strings of the plurality of cell strings are distributed at two opposite sides of the highest point of the at least one crest; and/or
adjacent cell strings of the plurality of cell strings are distributed at two facing sides of a lowest point of the at least one trough.

2. The curved photovoltaic module according to claim 1, wherein the plurality of cells in each of the plurality of cell strings are arranged in series in a direction perpendicular to the tangent direction of the highest point of the at least one crest.

3. The curved photovoltaic module according to claim 1, wherein the cell strings located at two opposite sides of a highest point of one of the at least one crest are connected in parallel to form a cell pack, a plurality of cell packs being connected in series.

4. The curved photovoltaic module according to claim 3, wherein:
in a direction perpendicular to the tangent direction of the highest point of the at least one crest, a positive electrode and a negative electrode are led out from two opposite ends of each of the plurality of cell strings, respectively;
for each of the plurality of cell packs, the positive electrodes of the cell strings in the cell pack are located at one end of the cell pack and connected to each other to serve as a positive electrode of the cell pack, and the negative electrodes of the cell strings in the cell pack are located at the other end of the cell pack and connected to each other to serve as a negative electrode of the cell pack; and
same ends of adjacent cell packs of the plurality of cell packs have opposite polarities.

5. The curved photovoltaic module according to claim 1, wherein the plurality of cells are multi-sectioned cells corresponding to a whole cell.

6. The curved photovoltaic module according to claim 1, wherein a curvature radius of the curved photovoltaic module is in a value range of greater than or equal to 50 mm and smaller than or equal to 150 mm.

7. The curved photovoltaic module according to claim 1, further comprising a front panel, a back panel, a first encapsulant film layer, and a second encapsulant film layer, the front panel, the first encapsulant film layer, the cell layer, the second encapsulant film layer, and the back panel being sequentially stacked, wherein the first encapsulant film layer is configured to bond the front panel and the cell layer, wherein the second encapsulant film layer is configured to bond the cell layer and the back panel, and wherein:
the front panel is a curved front panel, and the cell layer bends conformably with a shape of the front panel; or
the front panel is the curved front panel, the back panel is a curved back panel, and the cell layer bends conformably with shapes of both the front panel and the back panel.

8. The curved photovoltaic module according to claim 7, wherein:
the front panel is a light-transmitting curved front panel and is made of tempered glass, semi-tempered glass, or resin material;
the first encapsulant film layer is a high cut-off encapsulant film and is made of ethylene-vinyl acetate copolymer, polyolefin elastomer, polyvinyl butyral, or thermoplastic elastomer;
the second encapsulant film layer is a high light-transmitting encapsulant film and is made of ethylene-vinyl acetate copolymer, polyolefin elastomer, or polyvinyl butyral; and
the back panel is a curved back panel or a flexible back panel, wherein: when the back panel is the curved back panel, the back panel is made of tempered glass or semi-tempered glass; or when the back panel is the flexible back panel, the back panel is made of polyethylene glycol terephthalate, copper-covered ceramic, or glass fiber composite material.

9. The curved photovoltaic module according to claim 7, wherein:
a thickness of the front panel is in a value range of greater than or equal to 3 mm and smaller than or equal to 8 mm;
a thickness of the first encapsulant film layer is in a value range of greater than or equal to 0.3 mm and smaller than or equal to 0.8 mm;
a thickness of the second encapsulant film layer is in a value range of greater than or equal to 0.3 mm and smaller than or equal to 0.8 mm; and
when the back panel is a flexible back panel, a thickness of the back panel is in a value range of greater than or equal to 0.3 mm and smaller than or equal to 0.7 mm.

10. A curved photovoltaic module, comprising:
a cell layer comprising a plurality of series groups, each of the plurality of series groups comprising at least one cell string, each of the at least one cell string comprising a plurality of cells connected in series;
wherein the curved photovoltaic module comprises at least one crest, in a tangent direction of a highest point of the at least one crest, at least one series group being disposed at each of two opposite sides of the highest point of the at least one crest, and the series groups located at the two opposite sides of the highest point of the at least one crest being connected in parallel.

11. The curved photovoltaic module according to claim 10, wherein each of the plurality of series groups comprises one cell string, or each of the plurality of series groups comprises a plurality of cell strings connected in series and/or in parallel; and/or
wherein one series group of the plurality of series groups is provided at either side of the two opposite sides of the highest point of the at least one crest, or multiple series groups, connected in series and/or in parallel, of the plurality of series groups are provided at the either side of the two opposite sides of the highest point of the at least one crest.

12. The curved photovoltaic module according to claim 10, wherein the series groups located at two opposite sides of a highest point of one of the at least one crest are connected in parallel to form a cell pack, a plurality of cell packs being connected in series.

13. The curved photovoltaic module according to claim 10, wherein the plurality of cells are multi-sectioned cells corresponding to a whole cell.

14. The curved photovoltaic module according to claim 13, wherein:
each of the plurality of cells comprises a light receiving surface and a backlight surface, each of the light receiving surface and the backlight surface at least comprising a main grid line;
the plurality of cells in the cell string are arranged in an extension direction of the main grid line;
the main grid line of the light receiving surface of one of the plurality of cells is electrically connected to the main grid line of the backlight surface of an adjacent cell adjacent to the one cell; and
a polarity led out from the main grid line of the light receiving surface of one of the plurality of cells is opposite to a polarity led out from the main grid line of the backlight surface of an adjacent cell adjacent to the one cell.

15. The curved photovoltaic module according to claim 13, wherein:
each of the plurality of cells comprises a light receiving surface and a backlight surface, each of the light receiving surface and the backlight surface at least comprising a plurality of main grid lines;
the plurality of the cells in the cell string are arranged in a direction perpendicular to an extension direction of the plurality of main grid lines;
the plurality of main grid lines of the light receiving surface of one of the plurality of cells are electrically connected to the plurality of main grid lines of the backlight surface of an adjacent cell adjacent to the one cell; and
a polarity led out from the plurality of main grid lines of the light receiving surface of one of the plurality of cells is opposite to a polarity led out from the plurality of main grid lines of the backlight surface of an adjacent cell adjacent to the one cell.

16. The curved photovoltaic module according to claim 13, wherein:
each of the plurality of cells comprises a light receiving surface and a backlight surface, the backlight surface comprising a plurality of main grid lines;
the plurality of cells in the cell string is arranged in a direction perpendicular to an extension direction of the plurality of main grid lines;
the plurality of main grid lines of the backlight surface of one of the plurality of cells are electrically connected to the plurality of main grid lines of the backlight surface of an adjacent cell adjacent to the one cell; and
a polarity led out from the plurality of main grid lines on one side of the backlight surface of one of the plurality of cells is opposite to a polarity led out from the plurality of main grid lines on a same side of the backlight surface of an adjacent cell adjacent to the one cell.

17. The curved photovoltaic module according to claim 10, wherein:
an extension direction of the at least one cell string is perpendicular to the tangent direction of the highest point of the at least one crest; and
when each of the plurality of series groups comprises a plurality of cell strings, the plurality of cell strings are arranged in the tangent direction of the highest point of the at least one crest.

18. The curved photovoltaic module according to claim 10, further comprising a front panel, an encapsulant film layer, and a back panel, the front panel, the encapsulant film layer, the cell layer, the encapsulant film layer, and the back panel being sequentially stacked, wherein the encapsulant film layer is configured to bond the front panel and the cell layer or bond the cell layer and the back panel, and wherein:
the front panel is a curved front panel, and the cell layer bends conformably with a shape of the front panel; and/or
the back panel is a curved back panel, and the cell layer bends conformably with a shape of the back panel.

19. A photovoltaic building surface, comprising the curved photovoltaic module according to any one of claims 1 to 18.
